# EUROPEAN PATENT SPECIFICATION

(11) **EP 1 261 485 B1**
(45) Date of publication and mention of the grant of the patent: **02.03.2011**
(21) Application number: 01914004.5
(22) Date of filing: 08.03.2001
(51) Int. Cl.: B41F 15/34, B41F 15/36

(54) **IMPROVEMENTS RELATING TO SCREEN PRINTING APPARATUS**
VERBESSERUNGEN IN BEZUG AUF SIEBDRUCKMASCHINEN
APPAREIL DE SERIGRAPHIE AMELIORE

(30) Priority: 08.03.2000 GB 0005582
(43) Date of publication of application: 04.12.2002
(60) Divisional application: 10012032.8
(73) Proprietor: DTG International GmbH, 8005 Zürich (CH)
(72) Inventor: MCEVOY, Ian Patrick, Bath, BA2 6XD (GB); KNOWLES, John Bruce, Winfrith, Dorset DT2 8JW (GB)
(74) Representative: Boden, Keith McMurray
(86) International application number: PCT/GB2001/000999
(87) International publication number: WO 2001/066350

(56) References cited:
- WO-A-98/16387
- WO-A-99/14049
- DE-A- 4 239 995

## Description

The present invention relates to a print module for a screen printing apparatus, and a screen printing apparatus for and method of screen printing predeterminable patterns of material deposits onto workpieces, in particular, though not exclusively, electronic components such as circuit boards and the like.

Such circuit boards typically comprise a printed circuit board (PCB) or substrate on which various electronic components are mounted and connected to conductive tracks by an electrically-conductive material provide thereon in a predetermined pattern. In a first manufacturing step, an electrically-conductive material is printed on the printed circuit board or substrate through a printing screen. In a further manufacturing step, electronic components are then mounted to the printed circuit board or substrate such that those components are connected to the conductive tracks to form an electric circuit.

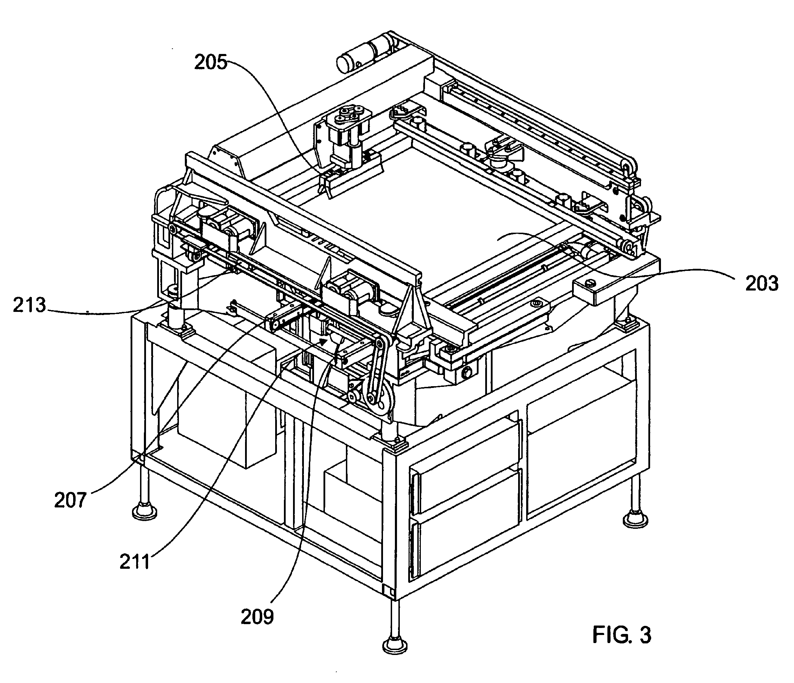

Figure 3 illustrates a known screen printing apparatus. The apparatus comprises a substantially immobile printing screen 203 and a print head 205 which is movable back and forth across the printing screen 203 along a Y axis to drive printing material through a pattern in the printing screen 203 and onto a workpiece disposed therebelow. The apparatus further comprises a workpiece transport device which includes a pair of transport rails 207, 209 along which workpieces are transported to the printing zone, and a workpiece support mechanism 211 disposed beneath the printing screen 203.

The apparatus further comprises a video camera 213 which is movable along X and Y axes to position the camera 213 at known positions between the workpiece and the printing screen 203 to measure any misalignment of the workpiece and the printing screen 203. Once any misalignment of the workpiece and the printing screen 203 has been measured, positioning actuators are operated as required to correctly align the workpiece with the printing screen 203 before printing commences. In this apparatus, X axis, Y axis and θ axis positioning actuators are provided to translate or rotate the printing screen 203, as required, and correctly align the printing screen 203 with the workpiece disposed therebelow. Typically, any movement of the printing screen 203 is limited to less than 10 mm or 1.5 degrees, and is purely for aligning the printing screen 203 with a workpiece to be printed.

Whilst the above-mentioned prior art screen printing apparatus is highly efficient in the high speed and high throughput production of PCBs, the apparatus lacks flexibility in being dedicated solely to screen printing and cannot easily be combined with other functions.

A further disadvantage is that the prior art screen printing apparatus is of fixed size, each one being limited to printing onto a particular range of workpiece sizes, typically to a range of workpieces that are smaller than the printing screen.

The prior art screen printing apparatus is also limited to printing onto planar workpieces, as the printing screen is only movable to a limited extent in X, Y and θ axes. As electronic devices become smaller, it is envisaged that printing of non-planar workpieces may be required; such printing of non-planar workpieces not being possible with the prior art apparatus.

WO-A-99/14049 discloses a mini-stencil, which is tensionable independent of its thickness and allows for the printing of deposits onto circuit boards for the repair and/or replacement of components.

It is therefore an aim of the present invention to address, and preferably alleviate, the impact of at least some of the above-described disadvantages associated with the prior art screen printing apparatus.

Accordingly, the present invention provides a print module for a screen printing apparatus, the print module comprising, as a detachable unitary assembly, a printing screen, a print head movable across the printing screen, and a drive mechanism for moving the print head with respect to the printing screen.

Preferably, the print module further comprises a housing to which the printing screen, the print head and the drive mechanism are mounted.

Preferably, the drive mechanism comprises a continuous belt connected to the print head and a motor for driving the belt to move the print head across the printing screen.

Preferably, the drive mechanism comprises at least one actuator which is operable to drive the print head into pressure contact with the printing screen.

Preferably, the print module further comprises a locator for locating the print module on the workpiece.

More preferably, the locator comprises a video camera which is movable with the print module to detect markers on the workpiece.

The present invention also provides a screen printing apparatus for printing a predeterminable pattern of deposits of printing material onto a workpiece, the screen printing apparatus comprising: at least one above-described print module; and a positioning unit for positioning a print module with respect to the workpiece.

Preferably, the print module is detachably mounted to the positioning unit.

More preferably, the apparatus comprises a plurality of print modules, with the printing screens of each being different.

Preferably, the positioning unit is configured to move the print module in a plane along substantially orthogonal X and Y axes, and vertically towards and away from the workpiece along a Z axis substantially orthogonal to the X and Y axes.

More preferably, the positioning unit is configured to rotate the print module about a point in the plane defined by the X and Y axes.

Yet more preferably, the positioning unit is configured to rotate the print module about the Z axis.

Preferably, the positioning unit is configured to rotate the print module about the X axis.

Preferably, the positioning unit is configured to rotate the print module about the Y axis.

In one embodiment the positioning unit is a robotic positioning arm.

In another embodiment the positioning unit is a positioning assembly comprising an arm extending substantially parallel to the Y axis and to which the print module is mounted, a beam extending substantially parallel to the X axis, a pillar extending substantially parallel to the Z axis, and drive members for providing relative movement of the arm, the beam and the pillar.

Preferably, the positioning assembly further comprises a drive member for rotating the print module about the Z axis.

Preferably, the positioning assembly further comprises drive members for rotating the arm about the Y axis and the beam about the X axis.

Preferably, the positioning assembly further comprises a drive member for rotating the pillar about the Z axis.

Preferably, the printing screen has a smaller lateral dimension than that of the workpiece.

In a preferred embodiment the apparatus further comprises a workpiece transport device for transporting workpieces to the printing zone and a controller for controlling the operation of the apparatus.

The present invention also extends to a screen printing apparatus comprising a plurality of the above-described print modules, each having a different function, and movement means for selecting and moving the print modules. In a preferred embodiment the apparatus further comprises a controller for selecting and interchanging the print modules from the printing zone.

The present invention further provides a method of screen printing a predeterminable pattern of deposits of printing material onto a workpiece, the method comprising the steps of: picking up an above-described print module in an acquiring step; moving the selected print module to a predeterminable position above a workpiece in a printing zone; and moving the print module into abutment with the workpiece and operating the print module to print deposits of printing material onto the workpiece in a printing step.

Preferably, the method further comprises the steps of moving the print module out of abutment with the workpiece; transporting a printed workpiece from the printing zone; and transporting another workpiece to the printing zone.

More preferably, the method further comprises the step of: moving the print module into abutment with the other workpiece and operating the print module to print deposits of printing material onto the other workpiece in a printing step.

Preferably, the method further comprises the steps of: moving the print module to a cleaning station; and cleaning the print head.

It is an advantage of the present invention that the printing screen can be easily cleaned by lifting the print module from the workpiece and wiping the same on a cleaning station to remove any excess printing material and other debris from the printing screen. Once clean, the print module can be returned for further printing operations.

The present invention yet further provides a method of printing a predeterminable pattern of deposits of printing material onto a workpiece, the method comprising the steps of: selecting a first print module; printing deposits of printing material onto a workpiece using the first-selected print module; returning the first-selected print module; selecting a second print module; and printing deposits of printing material onto the workpiece using the second-selected print module; wherein at least one of the selected print modules is the above-described print module.

Preferably, the method further comprises the steps of: selecting a further print module; and printing deposits of printing material onto a workpiece using the further-selected print module.

In one embodiment the screen printing apparatus is provided as part of a kit which comprises a plurality of detachable and interchangeable units, such as, for example, a screen printing unit and a component placement unit, means for selecting one or more of the units and respective moving means for moving the one or more selected units with respect to a workpiece.

Preferred embodiments of the present invention will now be described hereinbelow by way of example only with reference to the accompanying drawings, in which:
Figure 1 illustrates a screen printing apparatus in accordance with a first embodiment of the present invention;
Figure 2 illustrates a screen printing apparatus in accordance with a second embodiment of the present invention; and
Figure 3 illustrates a prior art screen printing apparatus.

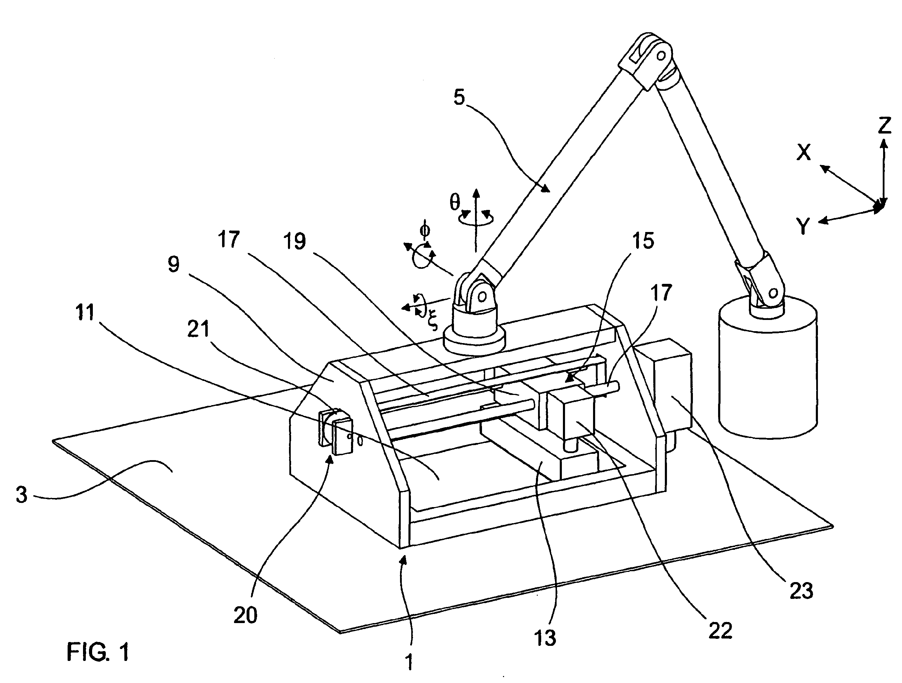

Figure 1 illustrates a screen printing apparatus in accordance with a first embodiment of the present invention.

The apparatus comprises a print module 1 for printing a pattern of deposits of a printing material on a workpiece 3. in this embodiment a circuit board, an articulated, robotic positioning arm 5 for positioning the print module 1 on the workpiece 3. and a controller for controlling the print module 1 and the robotic arm 5.

The apparatus further comprises a workpiece transport device for transporting workpieces 3 to a printing zone in which the print module 1 is operable to print material deposits on a respective workpiece 3. In a preferred embodiment the workpiece transport device includes a pair of guide rails along which workpieces 3 are transported to the printing zone.

The print module 1 is a unitary assembly which comprises a housing 9, a printing screen 11 which is mounted to the housing 9. a print head 13 which is movably disposed relative to the housing 9 to apply printing material to the printing screen 11 and print material deposits on the workpiece 3. and a carriage assembly 15 for supporting and driving the print head 13 over the printing screen 11.

The print head 13 comprises a squeegee print head or a pressure-driven print head as disclosed, for example, in WO-A-98/16387, the content of which is hereby incorporated by reference. In a preferred embodiment the print head 13 is a pressure-driven print head; such a print head 13 advantageously allowing for the printing of inverted workpieces 3.

The carriage assembly 15 comprises a pair of guide rails 17. 17 which are mounted to the housing 9, a support block 19 which is slideably disposed to the guide rails 17. 17 and supports the print head 13. and a drive unit 20 which includes a motor-driven continuous drive belt 21 for driving the support block 19 and hence the print head 13 over the printing screen 11. In alternative embodiments the carriage assembly 15 could be driven by a worm drive, a pulley system or any other conventional drive mechanism.

The carriage assembly 15 further comprises at least one actuator 22 for biasing the print head 13 into pressure contact with the printing screen 11 during printing.

The print module 1 further comprises an alignment system 23 for aligning the print module 1 to the workpiece 3 as required. In a preferred embodiment the alignment system 23 includes a video camera for locating fiducials or other locating indicators on the workpiece 3. One suitable system is disclosed in WO-A-95/14575 and US-A-5752446, the contents of which are hereby incorporated by reference.

In a preferred embodiment the print module 1 is detachable, preferably automatically, from the robotic arm 5 such that different print modules 1, for example, with differently patterned and/or sized printing screens 11, can be interchanged as required. In one embodiment the print module 1 could be interchanged for each print run, potentially comprising a single workpiece 3, to allow for the printing of different patterns and/or differently-sized workpieces 3. In another embodiment the print module 1 could be interchanged to allow for the printing of a plurality of different patterns and/or pattern sizes on a single workpiece 3. It is a particular advantage that the print module I can be readily interchanged, allowing for the use of print modules 1 having different screen patterns and/or screen sizes.

In this embodiment the print module I has a significantly smaller lateral dimension than the workpiece 3. In this way, the print module 1 can, for example, be operated to print in a recess in the surface of the workpiece 3. which recess would not be accessible when using a printing screen 11 having the same lateral dimension as the workpiece 3. and also print a plurality of different patterns on the same workpiece 3. The present invention thus enables different combinations of circuit patterns to be printed easily and rapidly on a workpiece 3 without the need for dedicated printing screens 11 for each of the particular combinations of circuit patterns. Of course, in other embodiments the print module I could have a lateral dimension the same size or greater than the workpiece 3.

The robotic arm 5 is configured to provide for movement of the print module 1 in the X, Y and Z axes, which movement allows for the positioning of the print module 1 on the surface of the workpiece 3. In this embodiment the robotic arm 5 is configured to provide for angular rotation ϕ, ξ, θ of the print module I about each of the X. Y and Z axes. By providing for angular rotation θ about the Z axis, that is, an axis perpendicular to the plane of the printing screen 11. a pattern in the printing screen 11 can be deposited with any orient on a planar surface of the workpiece 3. By further providing for angular rotation ϕ, ξ about the X and Y axes, the print module 1 can be translated and rotated to any position in space and allows for printing onto non-planar surfaces.

In this embodiment the robotic arm 5 is attached to the print module I by a mechanical connection. In this embodiment the robotic arm 5 includes a clamp and the print module I includes a structural feature, for example, a protrusion or a handle, which is engaged by the clamp on the robotic arm 5. In another embodiment the print module I includes a clamp and the robotic arm 5 includes a structural feature, for example, a protrusion or a handle, which is engaged by the clamp on the print module 1.

In another embodiment the robotic arm 5 can be attached to the print module 1 by a magnetic connection. In one variant the robotic arm 5 could include an electromagnet which is magnetically clamped to the print module 1. In another variant the print module 1 could include an electromagnet which is magnetically clamped to the robotic arm 5.

In this embodiment the controller is a programmable computer. The controller can be programmed to position the print module 1 at the required position or sequentially at the required positions and control the operation of the print module 1.

In one mode of operation, the controller is programmed to operate the workpiece transport device to inwardly transport a workpiece 3 to the printing zone, and then operate the robotic arm 5 first to pick up a selected print module I from a store in an acquiring step, position the selected print module I in a predetermined position above the workpiece 3. and then, in a printing step, move the selected print module 1 into abutment with the workpiece 3 and drive the print head 13 across the printing screen 11 to deposit a pattern of deposits of printing material onto the workpiece 3. The printing step can then be repeated on further workpieces 3 until a given print run is completed. Where a plurality of workpieces 3 are to be printed in a print run, then at the same time, while a workpiece 3 is being printed, a new workpiece 3 to be printed is transported to the printing zone and a printed workpiece 3 is transported from the printing zone. The print module 1 is then returned to the store by the robotic arm 5 under the control of the controller. In a subsequent print run, a different print module 1, for example, with a differently-patterned printing screen 11. could be picked up by the robotic arm 5, whereupon the above steps would then be repeated to provide a print run of workpieces 3 having the different printed pattern thereon. The printing steps may be interrupted with a cleaning step in which the print module 1 is moved to a cleaning station and the printing screen 11 wiped clean, as required.

In another mode of operation, where a customised pattern of deposits is to be printed using a plurality of print modules 1. the controller is programmed to operate the workpiece transport device to inwardly transport a workpiece 3 to the printing zone, and then operate the robotic arm 5 to in turn select and operate a plurality of different print modules 1 to achieve the required pattern of deposits of printing material, with the operation of each of the print modules I being as described hereinabove.

In a preferred embodiment the controller is programmable "on-the-fly" so that new instructions can be inputted, for example, for a print run requiring yet another print module 1. without having to interrupt the current print run.

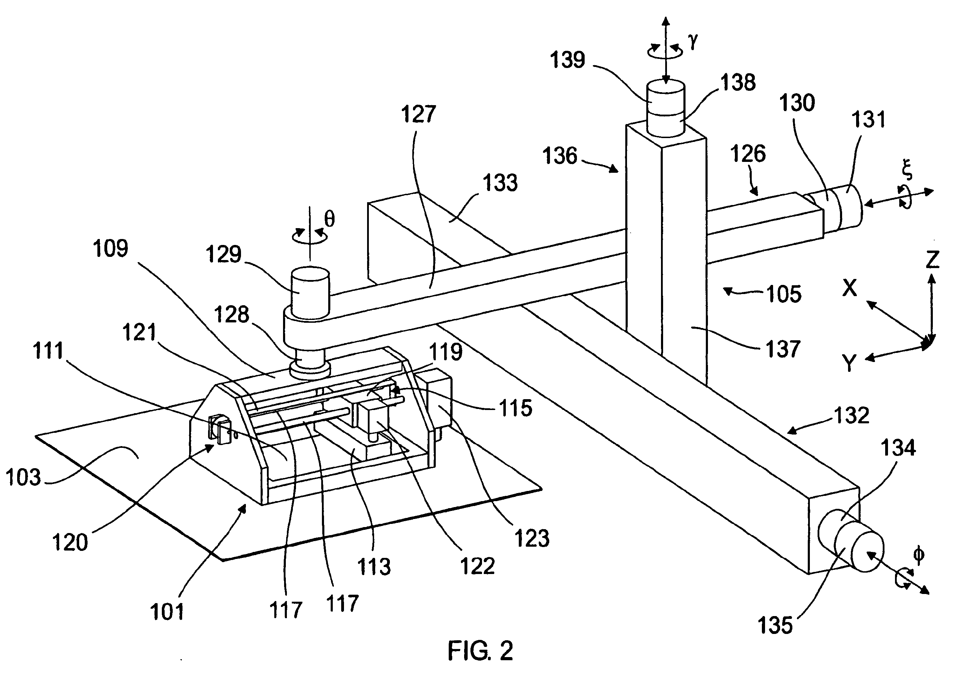

Figure 2 illustrates a screen printing apparatus in accordance with a second embodiment of the present invention. This embodiment utilises a Cartesian positioning system.

The apparatus comprises a print module 101 for printing a pattern of deposits of a printing material on a workpiece 103, a positioning assembly 105 for positioning the print module 101 on the workpiece 103, and a controller for controlling the print module 101 and the positioning assembly 105.

The apparatus further comprises a workpiece transport device for transporting workpieces 103 to a printing zone in which the print module 101 is operable to print material deposits on a respective workpiece 103. In a preferred embodiment the workpiece transport device includes a pair of guide rails along which workpieces 103 are transported to the printing zone.

The print module 101 is a unitary assembly which comprises a housing 109. a printing screen 111 which is mounted to the housing 109, a print head 113 which is movably disposed relative to the housing 109 to apply printing material to the printing screen 111 and print material deposits on the workpiece 103, and a carriage assembly 115 for supporting and driving the print head 13 over the printing screen 111.

The print head 113 comprises a squeegee print head or a pressure-driven print head as disclosed, for example, in WO-A-98/16387, the content of which is hereby incorporated by reference. In a preferred embodiment the print head 113 is a pressure-driven print head; such a print head 113 advantageously allowing for the printing of inverted workpieces 103.

The carriage assembly 115 comprises a pair of guide rails 117, 117 which are mounted to the housing 109, a support block 119 which is slideably disposed to the guide rails 117, 117 and supports the print head 113, and a drive unit 120 which includes a motor-driven continuous drive belt 121 for driving the support block 119 and hence the print head 113 over the printing screen 111. In alternative embodiments the carriage assembly 115 could be driven by a worm drive, a pulley system or any other conventional drive mechanism.

The carriage assembly 115 further comprises at least one actuator 122 for biasing the print head 113 into pressure contact with the printing screen 111 during printing.

The print module 101 further comprises an alignment system 123 for aligning the print module 101 to the workpiece 103 as required. In a preferred embodiment the alignment system 123 includes a video camera for locating fiducials or other locating indicators on the workpiece 103. One suitable system is disclosed in WO-A-95/14575 and US-A-5752446, the contents of which are hereby incorporated by reference.

In a preferred embodiment the print module 101 is detachable, preferably automatically, from the positioning assembly 105 such that different print modules 101, for example, with differently patterned and/or sized printing screens 111. can be interchanged as required. In one embodiment the print module 101 could be interchanged for each print run, potentially comprising a single workpiece 103, to allow for the printing of different patterns and/or differently-sized workpieces 103. In another embodiment the print module 101 could be interchanged to allow for the printing of a plurality of different patterns and/or pattern sizes on a single workpiece 103. It is a particular advantage that the print module 101 can be readily interchanged, allowing for the use of print modules 101 having different screen patterns and/or screen sizes.

In this embodiment the print module 101 has a significantly smaller lateral dimension than the workpiece 103. In this way, the print module 101 can be operated to print in a recess in the surface of the workpiece 103, which recess would not be accessible when using a printing screen 111 having the same lateral dimension as the workpiece 103. and also print a plurality of different patterns on the same workpiece 103. The present invention thus enables different combinations of circuit patterns to be printed easily and rapidly on a workpiece 103 without the need for dedicated printing screens 111 for each of the particular combinations of circuit patterns. Of course, in other embodiments the print module 101 could have a lateral dimension the same size or greater than the workpiece 103.

The positioning assembly 105 is configured to provide for movement of the print module 101 in the X. Y and Z axes, which movement allows for the positioning of the print module 101 on the surface of the workpiece 103.

The positioning assembly 105 includes an arm unit 126 which comprises an arm 127 which extends in a direction substantially parallel to the Y axis, a coupling 128 which is disposed at the distal end of the arm 127 and to which the print module 101 is mounted, a first arm drive member 129, in this embodiment a motor, for providing angular rotation θ of the print module 101 relative to the arm 127 about the Z axis, a second arm drive member 130, in this embodiment a motor, for driving the arm 127 and hence translating the print module 101 in the Y axis, and a third arm drive member 131, in this embodiment a motor, for providing angular rotation ξ of the arm 127 and hence the print module 101 about the Y axis.

In this embodiment the coupling 128 of the arm unit 126 of the positioning assembly 105 is attached to the print module 101 by a mechanical connection. In this embodiment the coupling 128 includes a clamp and the print module 101 includes a structural feature, for example, a protrusion or a handle, which is engaged by the clamp on the coupling 128. In another embodiment the print module 101 includes a clamp and the coupling 128 includes a structural feature, for example, a protrusion or a handle, which is engaged by the clamp on the print module 1.

In another embodiment the coupling 128 on the arm unit 126 of the positioning assembly 105 can be attached to the print module 101 by a magnetic connection. In one variant the coupling 128 could include an electromagnet which is magnetically clamped to the print module 101. In another variant the print module 101 could include an electromagnet which is magnetically clamped to the coupling 128.

The positioning assembly 105 further includes a beam unit 132 which comprises a beam 133 which extends in a direction substantially parallel to the X axis and to which the arm 127 of the arm unit 126 is movably disposed, a first beam drive member 134, in this embodiment a motor, for driving the beam 133 and hence translating the print module 101 in the X axis, and a second beam drive member 135 for providing angular rotation ϕ of the beam 133 and hence the print module 101 about the X axis.

The positioning assembly 105 further includes a pillar unit 136 which comprises a pillar 137 which extends in a direction substantially parallel to the Z axis and to which the beam 133 is movably disposed, a first pillar drive member 138, in this embodiment a motor, for driving the pillar 137 and hence translating the print module 101 in the Z axis, and a second pillar drive member 139 for providing angular rotation γ of the pillar 137 about the Z axis and hence rotate the print module 101 in an arc about the Z axis.

By providing for angular rotation θ of the print module 101 about the Z axis, that is, an axis perpendicular to the plane of the printing screen 111. a pattern in the printing screen 111 can be deposited with any orient on a planar surface. By further providing for angular rotation ϕ, ξ about the X and Y axes, the print module 101 can be translated and rotated to any position in space and allows for the printing onto non-planar surfaces.

In this embodiment the controller is a programmable computer. The controller can be programmed to position the print module 1 at the required position or sequentially at the required positions and control the operation of the print module 1.

In one mode of operation, the controller is programmed to operate the workpiece transport device to inwardly transport a workpiece 103 to the printing zone, and then operate the positioning assembly 105 first to pick up a selected print module 101 from a store in an acquiring step, position the selected print module 101 in a predetermined position above the workpiece 103, and then, in a printing step, move the selected print module 101 into abutment with the workpiece 103 and drive the print head 113 across the printing screen 111 to deposit a pattern of deposits of printing material onto the workpiece 103. The printing step can then be repeated on further workpieces 103 until a given print run is completed. Where a plurality of workpieces 103 are to be printed in a print run, then at the same time, while a workpiece 103 is being printed, a new workpiece 103 to be printed is transported to the printing zone and a printed workpiece 103 is transported from the printing zone. The print module 101 is then returned to the store by the positioning assembly 105 under the control of the controller. In a subsequent print run, a different print module 101, for example, with a differently-patterned printing screen 111, could be picked up by the positioning assembly 105, whereupon the above steps would then be repeated to provide a print run of workpieces 103 having the different printed pattern thereon. The printing steps may be interrupted with a cleaning step in which the print module 101 is moved to a cleaning station and the printing screen 111 wiped clean, as required.

In another mode of operation, where a customised pattern of deposits is to be printed using a plurality of print modules 101, the controller is programmed to operate the workpiece transport device to inwardly transport a workpiece 103 to the printing zone, and then operate the positioning assembly 105 to in turn select and operate a plurality of different print modules 101 to achieve the required pattern of deposits of printing material, with the operation of each of the print modules 101 being as described hereinabove.

In a preferred embodiment the controller is programmable "on-the-fly" so that new instructions can be inputted, for example, for a print run requiring yet another print module 101, without having to interrupt the current print run.

Finally, it will be understood that the present invention has been described in its preferred embodiments and can be modified in many different ways without departing from the scope of the invention as defined by the appended claims.

In other embodiments various other mechanisms can be utilised to position the print module 1. 101. The only necessary movement of the print module 1. 101 is in the X, Y and Z directions, with angular rotation θ of the print module 1. 101 about the Z axis, that is, an axis perpendicular to the printing screen 11. 111. being preferable.

In another modification, whilst the above-described embodiments provide a printing module 1. 101 of unitary construction which is positioned by a robotic arm 5 or positioning assembly 105, the apparatus could include first and second robotic arms 5 or positioning assemblies 105 for separately positioning and operating the printing screen 11, 111 and the print head 13, 113.

It will also be understood that the screen printing apparatus of the present invention need not be used alone as a dedicated screen printer, but could be incorporated in other equipment. In one embodiment the screen printing apparatus could form part of another machine with a different function, for example, a component placing mechanism.

## Claims

1. A print module for a screen printing apparatus, **characterized by** the print module (1; 101) comprising, as a detachable unitary assembly, a printing screen (11; 111), a print head (13; 113) movable across the printing screen (11; 111), and a drive mechanism (20; 120) for moving the print head (13; 113) with respect to the printing screen (11; 111).

2. The print module of claim 1, further comprising a housing (9; 109) to which the printing screen (11; 111), the print head (13; 113) and the drive mechanism (20; 120) are mounted.

3. The print module of claim 1 or 2, wherein the drive mechanism (20; 120) comprises a continuous belt (21; 121) connected to the print head (13; 113) and a motor for driving the belt (21; 121) to move the print head (13; 113) across the printing screen (11; 111).

4. The print module of any of claims 1 to 3, wherein the drive mechanism (20; 120) comprises at least one actuator (22; 122) which is operable to drive the print head (13; 113) into pressure contact with the printing screen (11; 111).

5. The print module of any of claims 1 to 4, further comprising a locator for locating the print module on a workpiece (3; 103).

6. The print module of claim 5, wherein the locator comprises a video camera which is movable with the print module (1; 101) to detect markers on the workpiece (3; 103).

7. A screen printing apparatus for printing a predeterminable pattern of deposits of printing material onto a workpiece (3; 103), the screen printing apparatus comprising:
at least one print module (1; 101) of any of claims 1 to 6; and
a positioning unit for positioning a print module (1; 101) with respect to the workpiece (3; 103).

8. The apparatus of claim 7, wherein the print module (1; 101) is detachably mounted to the positioning unit.

9. The apparatus of claim 8, comprising a plurality of print modules (1; 101), with the printing screens (11; 111) of each being different.

10. The apparatus of any of claims 7 to 9, wherein the positioning unit is configured to move the print module (1; 101) in a plane along substantially orthogonal X and Y axes, and vertically towards and away from the workpiece (3; 103) along a Z axis substantially orthogonal to the X and Y axes.

11. The apparatus of claim 10, wherein the positioning unit is configured to rotate the print module (1; 101) about a point in the plane defined by the X and Y axes.

12. The apparatus of claim 11, wherein the positioning unit is configured to rotate the print module (1; 101) about the Z axis.

13. The apparatus of any of claims 10 to 12, wherein the positioning unit is configured to rotate the print module (1; 101) about the X axis.

14. The apparatus of any of claims 10 to 13, wherein the positioning unit is configured to rotate the print module (1; 101) about the Y axis.

15. The apparatus of any of claims 10 to 14, wherein the positioning unit is a robotic positioning arm (5).

16. The apparatus of any of claims 10 to 14, wherein the positioning unit is a positioning assembly (105) comprising an arm (127) extending substantially parallel to the Y axis and to which the print module (101) is mounted, a beam (133) extending substantially parallel to the X axis, a pillar (137) extending substantially parallel to the Z axis, and drive members (130, 134, 138) for providing relative movement of the arm (127), the beam (133) and the pillar (137).

17. The apparatus of claim 16, wherein the positioning assembly (105) further comprises a drive member (129) for rotating the print module (101) about the Z axis.

18. The apparatus of claim 16 or 17, wherein the positioning assembly (105) further comprises drive members (131, 135) for rotating the arm (127) about the Y axis and the beam (133) about the X axis.

19. The apparatus of any of claims 16 to 18, wherein the positioning assembly (105) further comprises a drive member (139) for rotating the pillar (137) about the Z axis.

20. The apparatus of any of claims 7 to 19, wherein the printing screen (11; 111) has a smaller lateral dimension than that of the workpiece (3; 103).

21. A method of screen printing a predeterminable pattern of deposits of printing material onto a workpiece (3; 103), the method comprising the steps of:
picking up a print module (1; 101) of any of claims 1 to 6 in an acquiring step;
moving the selected print module (1; 101) to a predeterminable position above a workpiece (3; 103) in a printing zone; and
moving the print module (1; 101) into abutment with the workpiece (3; 103) and
operating the print module (1; 101) to print deposits of printing material onto the workpiece (3; 103) in a printing step.

22. The method of claim 21, further comprising the steps of:
moving the print module (1; 101) out of abutment with the workpiece (3; 103);
transporting a printed workpiece (3; 103) from the printing zone; and
transporting another workpiece (3; 103) to the printing zone.

23. The method of claim 22, further comprising the step of:
moving the print module (1; 101) into abutment with the other workpiece (3; 103) and operating the print module (1; 101) to print deposits of printing material onto the other workpiece (3; 103) in a printing step.

24. The method of any of claims 21 to 23, further comprising the steps of:
moving the print module (1; 101) to a cleaning station; and
cleaning the print head (13; 113).

25. A method of printing a predeterminable pattern of deposits of printing material onto a workpiece (3; 103), the method comprising the steps of
selecting a first print module (1; 101);
printing deposits of printing material onto a workpiece (3; 103) using the first-selected print module (1; 101);
returning the first-selected print module (1; 101);
selecting a second print module (1; 101); and
printing deposits of printing material onto the workpiece (3; 103) using the second-selected print module (1; 101);
wherein at least one of the selected print modules (1; 101) is a print module (1; 101) of any of claims 1 to 6.

26. The method of claim 25, further comprising the steps of:
selecting a further print module (1; 101); and
printing deposits of printing material onto the workpiece (3; 103) using the further-selected print module (1; 101).

## Patentansprüche

1. Druckmodul für ein Siebdruckgerät, **dadurch gekennzeichnet, dass** das Druckmodul einen abnehmbaren einheitlichen Aufbau, ein Druckraster (11; 111), einen über das Druckraster(11; 111) bewegbaren Druckkopf (13; 113) und einen Antriebsmechanismus (20; 120) zur Bewegung des Druckkopfes (13; 113) bezüglich des Druckrasters (11; 111) aufweist.

2. Druckmodul nach Anspruch 1, desweiteren aufweisend ein Gehäuse (9; 109), dem das Druckraster (11; 111), der Druckkopf (13; 113) und der Antriebsmechanismus (20; 120) zugeordnet sind.

3. Druckmodul nach Anspruch 1 oder 2, wobei der Antriebsmechanismus (20; 120) einen mit dem Druckkopf (13; 113) verbundenen durchgängigen Riemen (21; 121) zur Bewegung des Druckkopfes (13; 113) über das Druckraster(11; 111) aufweist.

4. Druckmodul nach einem der Ansprüche 1 bis 3, wobei der Antriebsmechanismus (20; 120) mindestens einen Antrieb (22; 122) mit der Funktion aufweiset, den Druckkopf (13; 113) in Anpressung mit dem Druckraster (11; 111) zu bringen.

5. Druckmodul nach einem der Ansprüche 1 bis 4, desweiteren aufweisend einen Positionsgeber zur Positionsbestimmung des Druckmoduls auf einem Werkstück (3; 103).

6. Druckmodul nach Anspruch 5, wobei der Positionsgeber eine Videokamera aufweist, welche mit dem Druckmodul (1; 101) bewegbar ist um Markierungen auf dem Werkstück (3; 103) zu erkennen.

7. Siebdruckgerät zum Bedrucken eines vorherbestimmten Musters von Ablagerungen von Druckmaterial auf ein Werkstück (3; 103), das Siebdruckgerät aufweisend:
mindestens ein Druckmodul (1; 101) nach einem der Ansprüche 1 bis 6;
und eine Positioniereinheit zur Positionierung eines Druckmoduls (1; 101) relativ zu einem Werkstück (3; 103).

8. Gerät nach Anspruch 7, wobei das Druckmodul (1; 101) lösbar mit der Positioniereinheit verbunden ist.

9. Gerät nach Anspruch 8, aufweisend eine Mehrzahl an Druckmodulen (1; 101), wovon das Druckraster (11; 111) jedes einzelnen unterschiedlich ist.

10. Gerät nach einem der Ansprüche 7 bis 9, wobei die Positioniereinheit konfiguriert ist, um das Druckmodul (1; 101) im Wesentlichen in einer Ebene orthogonal entlang X- und Y-Achse und vertikal zu und gegen das Werkstück entlang der Z-Achse im Wesentlichen orthogonal zur X- und Y-Achse zu bewegen.

11. Gerät nach Anspruch 10, wobei die Positioniereinheit konfiguriert ist, um das Druckmodul (1; 101) um einen Punkt in der von X- und Y-Achse definierten Ebene zu drehen.

12. Gerät nach Anspruch 11, wobei die Positioniereinheit konfiguriert ist, um das Druckmodul (1; 101) um die Z-Achse zu drehen.

13. Gerät nach einem der Ansprüche 10 bis 12, wobei die Positioniereinheit konfiguriert ist, um das Druckmodul (1; 101) um die X-Achse zu drehen.

14. Gerät nach einem der Ansprüche 10 bis 13, wobei die Positioniereinheit konfiguriert ist, um das Druckmodul (1; 101) um die Y-Achse zu drehen.

15. Gerät nach einem der Ansprüche 10 bis 14, wobei die Positioniereinheit ein Roboterpositionierarm (5) ist.

16. Gerät nach einem der Ansprüche 10 bis 14, wobei die Positioniereinheit ein Positionieraufbau (105) ist, dieser aufweisend einen sich im Wesentlichen parallel zur Y-Achse erstreckenden Arm (127) welchem das Druckmodul (101) zugeordnet ist, einen sich im Wesentlichen parallel zur X-Achse erstreckenden Ausleger (133), eine sich im Wesentlichen parallel zur Z-Achse erstreckenden Stütze (137), und ein Antriebsmittel (130, 134, 138) zur Bereitstellung einer Relativbewegung des Arms (127), des Auslegers (133) und der Stütze (137).

17. Gerät nach Anspruch 16, wobei der Positionieraufbau (105) desweiteren ein Antriebsmittel (129) zur Drehung des Druckmoduls (101) um die Z-Achse aufweist.

18. Gerät nach Anspruch 16 oder 17, wobei der Positionieraufbau (105) desweiteren Antriebsmittel (131, 135) zur Drehung des Arms (127) um die Y-Achse und des Auslegers (133) um die X-Achse.

19. Gerät nach einem der Ansprüche 16 bis 18, wobei der Positionieraufbau (105) desweiteren ein Antriebsmittel (139) zur Drehung der Stütze (137) um die Z-Achse aufweist.

20. Gerät nach einem der Ansprüche 7 bis 19, wobei das Druckraster (11; 111) eine schmalere laterale Dimension als die des Werkstücks (3; 103) besitzt.

21. Verfahren zum Siebdrucken eines vorherbestimmten Musters von Ablagerungen von Druckmaterial auf ein Werkstück (3; 103), das Verfahren aufweisend die Schritte:
Aufnehmen eines Druckmoduls (1; 101) nach einem der Ansprüche 1 bis 6 in einem anbringenden Schritt;
Bewegen des gewählten Druckmoduls (1; 101) in eine vorherbestimmte Position über dem Werkstück (3; 103) in einer Druckzone; und
Bewegung des Druckmoduls (1; 101) zu einem Aufliegen auf dem Werkstück (3; 103) und
Betreiben des Druckmoduls (1; 101) um Druck-Ablagerungen von Druckmaterial auf das Werkstück (3; 103) in einem Druckschritt aufzudrucken.

22. Vertahren nach Anspruch 21, desweiteren aufweisend die Schritte:
Bewegung des Druckmoduls (1; 101) aus einem Aufliegen auf dem Werkstück (3; 103);
Transportieren eines bedruckten Werkstücks (3; 103) aus der Druckzone; und
Transportieren eines anderen Werkstücks (3; 103) in die Druckzone.

23. Verfahren nach Anspruch 22, desweiteren aufweisend den Schritt:
Bewegen des Druckmoduls (1; 101) in ein Aufliegen mit dem anderen Werkstück (3; 103) und Betreiben des Druckmoduls (1; 101) um Druck-Ablagerungen von Druckmaterial auf das Werkstück (3; 103) in einem Druckschritt aufzudrucken.

24. Verfahren nach einem der Ansprüche 21 bis 23, desweiteren aufweisend die Schritte:
Bewegung des Druckmoduls (1; 101) in eine Reinigungsstation; und
Reinigung des Druckkopfes (13; 113).

25. Verfahren zum Drucken eines vorherbestimmten Musters von Ablagerungen von Druckmaterial auf ein Werkstück (3; 103), das Verfahren aufweisend die Schritte:
Auswahl eines ersten Druckmoduls (1; 101);
Drucken von Ablagerungen von Druckmaterial auf ein Werkstück (3; 103) unter Verwendung deserst-gewählten Druckmoduls (1; 101);
Zurückbringen des erst-gewählten Druckmoduls (1; 101);
Auswahl eines zweiten Druckmoduls (1; 101); und
Drucken von Ablagerungen von Druckmaterial auf das Werkstück (3; 103) unter Verwendung des zweit-gewählten Druckmoduls (1; 101);
wobei mindestens eines der gewählten Druckmodule (1; 101) ein Druckmodul (1; 101) nach einem der Ansprüche 1 bis 6 ist.

26. Verfahren nach Anspruch 25, desweiteren aufweisend die Schritte:
Auswahl eines weiteren Druckmoduls (1; 101); und
Drucken von Ablagerungen von Druckmaterial auf das Werkstück (3; 103) unter Verwendung des weiteren gewählten Druckmoduls (1; 101).

## Revendications

1. Module d'impression pour un appareil de sérigraphie, **caractérisé en ce que** le module d'impression (1 ; 101) comprend, sous forme d'ensemble unitaire séparable, un écran d'impression (11 ; 111), une tête d'impression (13 ; 113) mobile sur l'écran d'impression (11 ; 111), et un mécanisme d'entraînement (20 ; 120) pour déplacer la tête d'impression (13 ; 113) par rapport à l'écran d'impression (11 ; 111).

2. Module d'impression selon la revendication 1, comprenant en outre un logement (9 ; 109) sur lequel l'écran d'impression (11 ; 111), la tête d'impression (13 ; 113) et le mécanisme d'entraînement (20 ; 120) sont montés.

3. Module d'impression selon la revendication 1 ou 2, dans lequel le mécanisme d'entraînement (20 ; 120) comprend une courroie continue (21 ; 121) reliée à la tête d'impression (13 ; 113) et un moteur pour entraîner la courroie (21 ; 121) pour déplacer la tête d'impression (13 ; 113) sur l'écran d'impression (11 ; 111).

4. Module d'impression selon une quelconque des revendications 1 à 3, dans lequel le mécanisme d'entraînement (20 ; 120) comprend au moins un actionneur (22 ; 122) qui est opérationnel pour entraîner la tête d'impression (13 ; 113) en contact de pression avec l'écran d'impression (11 ; 111).

5. Module d'impression selon une quelconque des revendications 1 à 4, comprenant en outre un dispositif de positionnement pour positionner le module d'impression sur une pièce (3 ; 103).

6. Module d'impression selon la revendication 5, dans lequel le dispositif de positionnement comprend une caméra vidéo qui est mobile avec le module d'impression (1 ; 101) pour détecter des marqueurs sur la pièce (3 ; 103).

7. Appareil de sérigraphie pour imprimer un motif pouvant être prédéterminé de dépôts de matériau d'impression sur une pièce (3 ; 103), l'appareil de sérigraphie comprenant :
au moins un module d'impression (1 ; 101) selon une quelconque des revendications 1 à 6 ; et
une unité de positionnement pour positionner un module d'impression (1 ; 101) par rapport à la pièce (3 ; 103).

8. Appareil selon la revendication 7, dans lequel le module d'impression (1 ; 101) est monté de façon séparable sur l'unité de positionnement.

9. Appareil selon la revendication 8, comprenant une pluralité de modules d'impression (1 ; 101), les écrans d'impression (11 ; 111) de chacun étant différents.

10. Appareil selon une quelconque des revendications 7 à 9, dans lequel l'unité de positionnement est configurée pour déplacer le module d'impression (1 ; 101) dans un plan le long d'axes X et Y sensiblement orthogonaux, et verticalement pour le rapprocher et l'éloigner de la pièce (3 ; 103) le long d'un axe Z sensiblement orthogonal aux axes X et Y.

11. Appareil selon la revendication 10, dans lequel l'unité de positionnement est configurée pour faire tourner le module d'impression (1 ; 101) autour d'un point dans le plan défini par les axes X et Y.

12. Appareil selon la revendication 11, dans lequel l'unité de positionnement est configurée pour faire tourner le module d'impression (1 ; 101) autour de l'axe Z.

13. Appareil selon une quelconque des revendications 10 à 12, dans lequel l'unité de positionnement est configurée pour faire tourner le module d'impression (1 ; 101) autour de l'axe X.

14. Appareil selon une quelconque des revendications 10 à 13, dans lequel l'unité de positionnement est configurée pour faire tourner le module d'impression (1 ; 101) autour de l'axe Y.

15. Appareil selon une quelconque des revendications 10 à 14, dans lequel l'unité de positionnement est un bras de positionnement robotisé (5).

16. Appareil selon une quelconque des revendications 10 à 14, dans lequel l'unité de positionnement est un ensemble de positionnement (105) comprenant un bras (127) s'étendant de façon sensiblement parallèle à l'axe Y et sur lequel le module d'impression (101) est monté, un faisceau (133) s'étendant de façon sensiblement parallèle à l'axe X, un pilier (137) s'étendant de façon sensiblement parallèle à l'axe Z, et des éléments d'entraînement (130, 134, 138) pour fournir un mouvement relatif du bras (127), du faisceau (133) et du pilier (137).

17. Appareil selon la revendication 16, dans lequel l'ensemble de positionnement (105) comprend en outre un élément d'entraînement (129) pour faire tourner le module d'impression (101) autour de l'axe Z.

18. Appareil selon la revendication 16 ou 17, dans lequel l'ensemble de positionnement (105) comprend en outre des éléments d'entraînement (131, 135) pour faire tourner le bras (127) autour de l'axe Y et le faisceau (133) autour de l'axe X.

19. Appareil selon une quelconque des revendications 16 à 18, dans lequel l'ensemble de positionnement (105) comprend en outre un élément d'entraînement (139) pour faire tourner le pilier (137) autour de l'axe Z.

20. Appareil selon une quelconque des revendications 7 à 19, dans lequel l'écran d'impression (11 ; 111) possède une dimension latérale inférieure à celle de la pièce (3 ; 103).

21. Procédé de sérigraphie d'un motif pouvant être prédéterminé de dépôts de matériau d'impression sur une pièce (3 ; 103), le procédé comprenant les étapes consistant à :
sélectionner un module d'impression (1 ; 101) selon une quelconque des revendications 1 à 6 dans une étape d'acquisition ;
déplacer le module d'impression sélectionné (1 ; 101) jusqu'à une position pouvant être prédéterminée au-dessus d'une pièce (3 ; 103) dans une zone d'impression ; et
déplacer le module d'impression (1 ; 101) en butée avec la pièce (3 ; 103) et actionner le module d'impression (1 ; 101) pour imprimer des dépôts de matériau d'impression sur la pièce (3 ; 103) dans une étape d'impression.

22. Procédé selon la revendication 21, comprenant en outre les étapes consistant à :
déplacer le module d'impression (1 ; 101) hors de butée avec la pièce (3 ; 103) ;
transporter une pièce imprimée (3 ; 103) à partir de la zone d'impression ; et
transporter une autre pièce (3 ; 103) jusqu'à la zone d'impression.

23. Procédé selon la revendication 22, comprenant en outre les étapes consistant à :
déplacer le module d'impression (1 ; 101) en butée avec l'autre pièce (3 ; 103) et actionner le module d'impression (1 ; 101) pour imprimer des dépôts de matériau d'impression sur l'autre pièce (3 ; 103) dans une étape d'impression.

24. Procédé selon une quelconque des revendications 21 à 23, comprenant en outre les étapes consistant à :
déplacer le module d'impression (1 ; 101) jusqu'à un poste de nettoyage ; et
nettoyer la tête d'impression (13; 113).

25. Procédé d'impression d'un motif pouvant être prédéterminé de dépôts de matériau d'impression sur une pièce (3 ; 103), le procédé comprenant les étapes consistant à :
sélectionner un premier module d'impression (1 ; 101) ;
imprimer des dépôts de matériau d'impression sur une pièce (3 ; 103) en utilisant le premier module d'impression sélectionné (1 ; 101) ;
ranger le premier module d'impression sélectionné (1 ; 101) dans sa position d'origine ;
sélectionner un second module d'impression (1 ; 101) ; et
imprimer des dépôts de matériau d'impression sur la pièce (3 ; 103) en utilisant le second module d'impression sélectionné (1 ; 101) ;
dans lequel au moins un des modules d'impression sélectionnés (1 ; 101) est un module d'impression (1 ; 101) selon une quelconque des revendications 1 à 6.

26. Procédé selon la revendication 25, comprenant en outre les étapes consistant à :
sélectionner un module d'impression supplémentaire (1 ; 101) ; et
imprimer des dépôts de matériau d'impression sur la pièce (3 ; 103) en utilisant le module d'impression supplémentaire sélectionné (1 ; 101).
